# EUROPEAN PATENT APPLICATION

(11) **EP 4 006 767 A1**
(43) Date of publication of application: **01.06.2022**
(21) Application number: 19945109.7
(22) Date of filing: 10.09.2019
(51) Int. Cl.: G06F 30/33, G06F 30/27, G06N 3/02

(54) **SENSOR MODEL GENERATION METHOD AND SYSTEM, AND SENSOR MEASUREMENT METHOD AND SYSTEM**

(71) Applicant: Siemens Aktiengesellschaft, 80333 München (DE)
(72) Inventor: BAI, Xin, Beijing 100068 (CN); ZHOU, Xiao Zhou, Beijing 101199 (CN)
(74) Representative: Isarpatent
(86) International application number: PCT/CN2019/105197
(87) International publication number: WO 2021/046723

(57) **Abstract**

A sensor model generation method and system, a sensor measurement method and system, and a storage medium. The generation method comprises: predetermining at least one group of input parameter samples for a baseline simulation model (S11), obtaining one group of output parameter samples with respect to each group of input parameter samples, and using said input and output parameter samples as a group of samples saved in a sample set (S12); with respect to a single target sensor or a target sensor collection, utilizing a first number of samples in the sample set to train one constructed neural network model, so as to obtain a corresponding sensor provisional model; utilizing the remaining samples in the sample set to perform a check on the output precision of the sensor provisional model (S13); once the checked precision satisfies a set requirement, using each sensor provisional model as a sensor initial model for the corresponding single target sensor or the target sensor collection (S14-15). The sensor model generation method and system utilize sensor models to replace physical sensor in measuring the real performance of target devices.

## Description

### TECHNICAL FIELD

The present invention relates to the industrial field, and in particular to a sensor model generation method and system, a sensor measurement method and system, and a computer-readable storage medium.

### BACKGROUND OF THE INVENTION

In the industrial field, in order to make accurate predictions on problems in specific areas in the design stage, for example, evaluation of the design performance of target equipment, etc., it is usually necessary to use technologies such as finite element analysis (FEA), computational fluid dynamics (CFD), etc. to establish a baseline simulation model, and use the baseline simulation model for simulation with inputs of the relevant parameters under each working condition, to obtain an output of the corresponding performance and other parameters. When the output meets the expectation, it is determined that the design of the target equipment meets the requirements.

For example, to predict the deformation of each position of the C-arm of a C-arm X-ray machine, at the design stage, the designer or engineer can iterate a series of prototypes/design concepts based on expertise using techniques such as finite element analysis (FEA), build a baseline simulation model, and obtain the deformation value of each position of the C-arm by inputting parameters such as material parameters, boundary conditions, geometric dimensions, force bearing points, etc. A predicted value obtained based on the baseline simulation model is usually an accurate value. Therefore, when the predicted deformation values meet the expectation, it can be determined that the C-arm design of the C-arm X-ray machine meets the design requirements, so that it can be delivered from the factory for use.

In the use stage after delivery from the factory, to monitor and evaluate the actual performance of the target equipment, it is necessary to rely on the actual measurement values of physical sensors installed at various locations on the site or derived values from empirical models.

### BRIEF SUMMARY OF THE INVENTION

In view of this, a sensor model generation method and system is proposed in one aspect in the embodiments of the present invention, and a sensor measurement method and system and a computer-readable storage medium are proposed in another aspect, intended to use sensor models to replace physical sensors to monitor the actual performance of target equipment.

A sensor model generation method proposed in the embodiments of the present invention comprises: determining at least one set of input parameter samples for a baseline simulation model; for each set of input parameter samples, inputting the input parameter samples into the baseline simulation model, to obtain a corresponding set of output parameters, and selecting output parameters corresponding to a plurality of predetermined target measurement positions from the set of output parameters as the output parameter samples of a plurality of target sensors; storing the input parameter samples and the output parameter samples in a sample set as one set of samples; for a single target sensor or a combination of target sensors, training a constructed neural network by use of the input parameter sample of each sample in a first number of samples in the sample set and an output parameter corresponding to the single target sensor or the combination of target sensors, to obtain a temporary sensor model corresponding to the single target sensor or the combination of target sensors; verifying output accuracy of the temporary sensor model by use of the input parameter sample of each sample in a remaining second number of samples in the sample set and an output parameter corresponding to the single target sensor or the combination of target sensors; and for at least one temporary sensor model, when the verified accuracy meets a set requirement, taking each temporary sensor model as an initial sensor model of the corresponding single target sensor or combination of target sensors.

In one implementation, it further comprises: when the verified accuracy does not meet the set requirement, returning to the step of determining at least one set of input parameter samples.

In one implementation, it further comprises: taking the sample set of the initial sensor model of each of the single target sensor and/or combination of target sensors obtained by training as a target sample set; for at least one current candidate target measurement position to be arranged for a single physical sensor or a combination of physical sensors determined in a set manner, for a single target sensor or a combination of target sensors at other target measurement positions, selecting at least one output parameter corresponding to the at least one current candidate target measurement position from the output parameter samples of each sample in the target sample set as a current auxiliary input parameter, adding it to the input parameter samples of the sample to form current input parameter samples, and training a constructed neural network by use of the current input parameter sample of each sample in a first number of samples in the target sample set and an output parameter of the corresponding single target sensor or the combination of target sensors, to obtain an optimized sensor model corresponding to the single target sensor or the combination of target sensors; and verifying output accuracy of the optimized sensor model by use of the current input parameter sample of each sample in a second number of samples in the target sample set and an output parameter of the corresponding single target sensor or the combination of target sensors; for at least one current candidate target measurement position, obtaining an optimized sensor model set comprising at least one optimized sensor model of other target measurement positions; and, according to each optimized sensor model set obtained at each candidate target measurement position, selecting at least one final candidate target measurement position and a final optimized sensor model set based on the verified accuracy of each optimized sensor model.

A sensor measurement method proposed in the embodiments of the present invention comprises: at M1 measurement positions among M measurement positions, using N sensor models for simulated measurement; at the remaining M2 measurement positions among the M measurement positions, using M2 physical sensors for real measurement; wherein, M = M1 + M2, and M1 is greater than or equal to N; and M, M1 and N each are an integer greater than or equal to 1, and M2 is an integer greater than or equal to 0; the N sensors comprise N1 initial sensor models and N2 optimized sensor models taking the output values of the M2 physical sensors as auxiliary input parameters; wherein, N = N1 + N2, N1 and N2 each are an integer greater than or equal to 0, and they are not simultaneously 0; the initial sensor model is obtained by the sensor model generation method described in claim 1 or 2; and the optimized sensor model and the measurement positions of the M2 physical sensors are obtained by the sensor model generation method described in claim 3.

A sensor model generation system proposed in the embodiments of the present invention comprises: a first determining module, used to determine at least one set of input parameter samples for a baseline simulation model; a sample obtaining module, used to, for each set of input parameter samples, input the input parameter samples into the baseline simulation model, to obtain a corresponding set of output parameters, and select output parameters corresponding to a plurality of predetermined target measurement positions from the set of output parameters as the output parameter samples of a plurality of target sensors; and store the input parameter samples and the output parameter samples in a sample set as one set of samples; a first model training module, used to, for a single target sensor or a combination of target sensors, train a constructed neural network by use of the input parameter sample of each sample in a first number of samples in the sample set and an output parameter corresponding to the single target sensor or the combination of target sensors, to obtain a temporary sensor model corresponding to the single target sensor or the combination of target sensors; and verify output accuracy of the temporary sensor model by use of the input parameter sample of each sample in a remaining second number of samples in the sample set and an output parameter corresponding to the single target sensor or the combination of target sensors; and a model confirming module, used to, for at least one temporary sensor model, when the verified accuracy meets a set requirement, take each temporary sensor model as an initial sensor model of the corresponding single target sensor or combination of target sensors.

In one implementation, the model confirming module is further used to, when the verified accuracy does not meet the set requirement, notify the second determining module to perform the operation to determine at least one set of input parameter samples within the value range of each type of input parameters.

In one implementation, it further comprises: a second determining module, used to, take the sample set of the initial sensor model of each of the single target sensor and/or combination of target sensors obtained by training as a target sample set; a second model training module, used to, for at least one current candidate target measurement position to be arranged for a single physical sensor or a combination of physical sensors determined in a set manner, for a single target sensor or a combination of target sensors at other target measurement positions, select at least one output parameter corresponding to the at least one current candidate target measurement position from the output parameter samples of each sample in the target sample set as a current auxiliary input parameter, add it to the input parameter samples of the sample to form current input parameter samples, and train a constructed neural network by use of the current input parameter sample of each sample in a first number of samples in the target sample set and an output parameter corresponding to the single target sensor or the combination of target sensors, to obtain an optimized sensor model corresponding to the single target sensor or the combination of target sensors; verify output accuracy of the optimized sensor model by use of the current input parameter sample of each sample in a second number of samples in the target sample set and an output parameter corresponding to the single target sensor or the combination of target sensors; for at least one current candidate target measurement position, obtain an optimized sensor model set comprising at least one optimized sensor model of other target measurement positions; and a decision making module, used to, according to each optimized sensor model set obtained at each candidate target measurement position, select at least one final candidate target measurement position and a final optimized sensor model set based on the verified accuracy of each optimized sensor model.

A sensor measurement system proposed in the embodiments of the present invention comprises: N sensor modules, used to perform simulated measurement at M1 measurement positions among M measurement positions; and M2 physical sensors, used to perform real measurement at the remaining M2 measurement positions among the M measurement positions; wherein, M = M1 + M2, M1 is greater than or equal to N; and M, M1 and N each are an integer greater than or equal to 1, and M2 is an integer greater than or equal to 0; the N sensor models comprise N1 initial sensor models and N2 optimized sensor models taking the output values of the M2 physical sensors as auxiliary input parameters; wherein, N = N1 + N2, N1 and N2 each are an integer greater than or equal to 0, and they are not simultaneously 0; the initial sensor model is obtained by the sensor model generation method described in claim 5 or 6; and the optimized sensor model and the measurement positions of the M2 physical sensors are obtained by the sensor model generation method described in claim 3.

A sensor model generation system proposed in the embodiments of the present invention comprises: at least one memory and at least one processor, wherein: the at least one memory is used to store a computer program; the at least one processor is used to call the computer program stored in the at least one memory, to execute the sensor model generation method described in any of the above implementations.

A computer-readable storage medium proposed in the embodiments of the present invention has a computer program stored thereon; the computer program can be executed by a processor and implement the sensor model generation method described in any of the above implementations.

It can be seen from the above solution that, in the embodiments of the present invention, the characteristic of the relatively accurate prediction value of a baseline simulation model is used to obtain a sample set comprising a large number of samples composed of input parameters and corresponding output parameters, to train a neural network model of the required physical sensors and obtain a sensor model (i.e., a virtual sensor) corresponding to the required physical sensor, and then it is possible to use the sensor model to replace individual physical sensors, to perform simulated measurement at positions of target equipment where it is not suitable to install a physical sensor; in addition, it is also possible to reduce costs by replacing some physical sensors with certain sensor models.

Moreover, sensor models at other measurement positions are trained by use of the outputs of the baseline simulation model corresponding to certain measurement positions as auxiliary input parameters, thereby further improving the output accuracy of sensor models. In this way, in practice, physical sensors may be provided at these certain measurement positions, and their outputs, i.e., measured values, may be used as auxiliary input parameters for sensor models at other measurement positions, to obtain outputs of higher accuracy from sensors at other measurement positions.

In addition, by flexible combination of physical sensors, optimized sensor models and initial sensor models, it is possible to deal with various application scenarios, thereby improving the overall measurement accuracy of target equipment.

### BRIEF DESCRIPTION OF THE DRAWINGS

The preferred embodiments of the present invention will be described in detail below with reference to the drawings, so that those skilled in the art will better understand the above and other features and advantages of the present invention. In the drawings:
Figure 1 is an exemplary flowchart of a sensor model generation method in the embodiments of the present invention.
Figure 2A is an exemplary flowchart of another sensor model generation method in the embodiments of the present invention.
Figure 2B is a schematic diagram of the principle of the method shown in Figure 2A.
Figure 3A and Figure 3B are schematic diagrams of the accuracy of an optimized sensor model set at different candidate target measurement positions, taking displacement of the C-arm of an X-ray machine as the design target in one example of the present invention.
Figure 4 is a schematic diagram of a comparison of the outputs from a baseline simulation model, an initial sensor model and an optimized sensor model at different target measurement positions in one example of the present invention.
Figure 5 is an exemplary structural diagram of a sensor model generation system in the embodiments of the present invention.
Figure 6 is an exemplary structural diagram of another sensor model generation system in the embodiments of the present invention.
Figure 7 is an exemplary structural diagram of a sensor measurement system in the embodiments of the present invention.
Figure 8 is a schematic structural diagram of another sensor model generation system in the embodiments of the present invention.

In the drawings, the following reference numerals are used:

| Numeral | Meaning |
|---|---|
| S11 - S15, and S21 - S23 | Steps |
| 501 | First determining module |
| 502 | Sample obtaining module |
| 503 | First model training module |
| 504 | Model confirming module |
| 601 | Second determining module |
| 602 | Second model training module |
| 603 | Decision making module |
| 710 | Sensor model |
| 711 | Initial sensor model |
| 712 | Optimized sensor model |
| 720 | Physical sensor |
| 81 | Memory |
| 82 | Processor |
| 83 | Bus |

### DETAILED DESCRIPTION OF THE EMBODIMENTS

In order to be concise and intuitive in the description, the solution of the present invention is described below with reference to several representative embodiments. The large number of details in the embodiments are only used to help to understand the solution of the present invention. However, it is obvious that the technical solution of the present invention may not be limited to these details. In order to avoid unnecessarily obscuring the solution of the present invention, some embodiments are not described in detail, but only a framework is given. Hereinafter, "including" means "including but not limited to", and "according to..." means "at least according to..., but not limited to...". Due to Chinese language habits, when the quantity of an element is not specified hereinafter, it means that there may be one or several of the element, or it can be understood as there is at least one of it.

In the embodiments of the present invention, it is considered that, in practical applications, it may not be suitable to install physical sensors at some positions of the target equipment, or it is impossible to install a physical sensor at each target position based on cost or space considerations, and it is impossible to replace individual physical sensors with a baseline simulation model, because the output of a baseline simulation model outputs multiple predicted values, it is impossible to output a single predicted value of concern, and also the input and output of a baseline simulation model cannot be used for the prediction of real-time data. For this reason, in the embodiments of the present invention, it is construed that the characteristic of the relatively accurate prediction value of a baseline simulation model is used to obtain a sample set comprising a large number of samples composed of input parameters and corresponding output parameters, to train a neural network model and obtain a sensor model (i.e., a virtual sensor) corresponding to the required physical sensor, and then it is possible to use the sensor model to replace individual physical sensors.

The present invention is further described in detail with reference to the drawings and the embodiments, so that its technical solution and advantages become clearer. It should be understood that the specific embodiments described here are only used to illustratively explain the present invention, and are not used to limit the scope of the present invention.

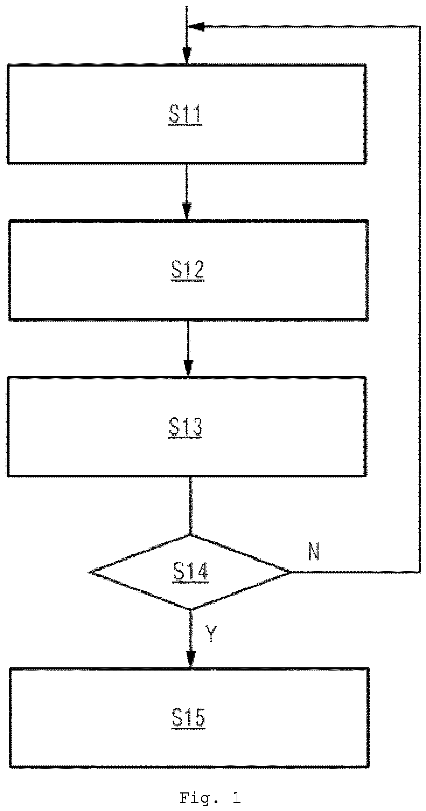

Figure 1 is an exemplary flowchart of a sensor model generation method in the embodiments of the present invention. As shown in Figure 1, the method may comprise the following steps:
Step S11, determining at least one set of input parameter samples of a baseline simulation model.

In this step, the baseline simulation model may have the types of input parameters determined based on the design target of the target object, and the value ranges of various types of input parameters determined based on possible working conditions or empirical values, etc. For example, if the design target of the target object is the deformation of a robot arm, the types of input parameters may include: material parameters, boundary conditions such as force bearing points and force values, parameters required for simulation, etc. Accordingly, at least one set of input parameter samples can be determined within the value range of each type of input parameters. For example, according to the value range of each type of input parameters, a set of values of each type of input parameters can be randomly determined within their respective range, to obtain a set of input parameter samples; and then a set of values of each type of input parameters can be randomly determined, to obtain another set of input parameter samples.

Step S12, for each set of input parameter samples, inputting the input parameter samples into the baseline simulation model, to obtain a corresponding set of output parameters, and selecting the output parameters corresponding to a plurality of predetermined target measurement positions from the set of output parameters as the output parameter samples of a plurality of target sensors; and storing the input parameter samples and the output parameter samples in a sample set as one set of samples.

In this step, a target measurement position means each potential position where a target sensor may need to be installed, and a plurality of target measurement positions may be determined based on the design target of the target object. For example, in the case where the design target of the target object is the deformation of a robot arm, it may be necessary to arrange a plurality of target measurement positions of target sensors, which may include a plurality of measurement positions distributed along the robot arm, for example, several, more than ten or even tens of measurement positions distributed along the robot arm.

In practical applications, the baseline simulation model will output a large number of output parameters corresponding to each set of input parameter samples, and these output parameters include many output parameters that are not points of interest in addition to those corresponding to the plurality of set target measurement positions. Therefore, in this step, only the output parameters corresponding to the plurality of target measurement positions can be selected as the output parameter samples corresponding to the input parameter samples, and the selected output parameter samples are the output parameter samples of the corresponding target sensors.

Step S13, for a single target sensor or a combination of target sensors, training a constructed neural network by use of the input parameter sample of each sample in a first number of samples in the sample set and an output parameter corresponding to the single target sensor or the combination of target sensors, to obtain a temporary sensor model corresponding to the single target sensor or the combination of target sensors; and verifying output accuracy of the temporary sensor model by use of the input parameter sample of each sample in a remaining second number of samples in the sample set and an output parameter corresponding to the single target sensor or the combination of target sensors. Generally, the first number is much greater than the second number.

In this step, if the sensor model is only trained for a single target sensor, the output parameter used for training and accuracy verification should be the output parameter corresponding to the target sensor in the output parameter samples, i.e., the output parameter corresponding to the target position where the target sensor needs to be installed; if the sensor model is trained for a combination of target sensors, for example, two target sensors corresponding to different target positions, the output parameters used for training and accuracy verification should be the output parameters corresponding to the combination of target sensors in the output parameter samples, i.e., the output parameters corresponding to two target sensors at different target positions.

Step S14, for at least one temporary sensor model, deciding whether the verified accuracy meets a set requirement, and if it does, performing Step S15; otherwise, returning to Step S11, to increase the number of samples in the sample set.

In this step, in consideration of the fact that there may be more than one sensor model to be trained, accordingly, the verified accuracy of a temporary sensor model obtained by training based on the same sample set may vary, for example, being higher for some while lower for others, and therefore the criterion used to determine the completion of the training may differ. For example, the training may be deemed completed when each temporary sensor model meets the accuracy requirement; or when most of the temporary sensor models meet the accuracy requirement; or, the accuracy requirement of each temporary sensor model is determined based on other calculation rules.

Step S15, taking each temporary sensor model as an initial sensor model of the corresponding single target sensor or combination of target sensors.

In this step, an initial sensor model of either a single target sensor or a combination of target sensors can be used in actual applications to replace physical sensors that cannot be installed at the corresponding positions or to reduce installed physical sensors in order to save costs. In addition, these initial sensor models may also be used for parameter prediction, product assessment, etc. in the product design stage.

Further, in consideration of the fact that the measured values of physical sensors at different positions of a single object may be correlated to a certain extent in actual applications, for example, for the deformation of a robot arm under forces, the measured values of physical sensors at adjacent measurement positions will be close to each other, in actual applications, physical sensors may be provided at some measurement positions, while sensor models are used at other positions for simulation, and the measured values of physical sensors are used as auxiliary input parameters for relevant sensor models. Based on this, in the embodiments of the present invention, optimized sensor models with auxiliary input parameters may be further trained, and the parameters at corresponding measurement positions output from the baseline simulation model may be used as the auxiliary input parameters at the training stage.

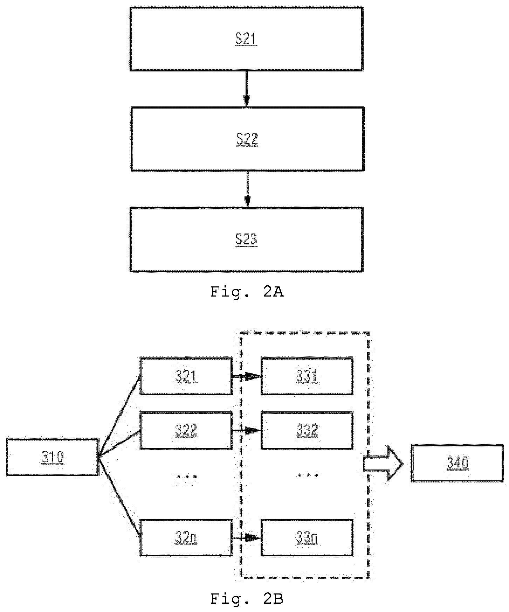

In specific implementation, the sample set of each initial sensor model obtained by training may be used for the training. For example, it can be specifically the exemplary flowchart of another sensor model generation method in another implementation as shown in Figure 2A, which comprises the following steps:
S21, taking the sample set of the initial sensor model of each single target sensor and/or combination of target sensors obtained by training in the embodiment shown in Figure 1 as a target sample set.
S22, for at least one current candidate target measurement position to be arranged for a single physical sensor or a combination of physical sensors determined in a set manner, for example, by polling or enumerating, for a single target sensor or a combination of target sensors at other target measurement positions, selecting at least one output parameter corresponding to the at least one current candidate target measurement position from the output parameter samples of each sample in the target sample set as a current auxiliary input parameter, adding it to the input parameter samples of the sample to form current input parameter samples, and training a constructed neural network by use of the current input parameter sample of each sample in a first number of samples in the target sample set and an output parameter corresponding to the single target sensor or the combination of target sensors, to obtain an optimized sensor model corresponding to the single target sensor or the combination of target sensors; and verifying output accuracy of the optimized sensor model by use of the current input parameter sample of each sample in a second number of samples in the target sample set and an output parameter corresponding to the single target sensor or the combination of target sensors; for at least one current candidate target measurement position, obtaining an optimized sensor model set comprising at least one optimized sensor model of other target measurement positions.

After Step S22, for each current candidate target measurement position or combination of current candidate target measurement positions, at least one optimized sensor model of other target measurement positions can be obtained. For simplification, the at least one optimized sensor model corresponding to each current candidate target measurement position or combination of current candidate target measurement positions is referred to as one optimized sensor model.

S23, according to each optimized sensor model set obtained at each candidate target measurement position, selecting at least one final candidate target measurement position (for example, a single candidate target measurement position or a combination of candidate target measurement positions) and a final optimized sensor model set based on the verified accuracy of each optimized sensor model.

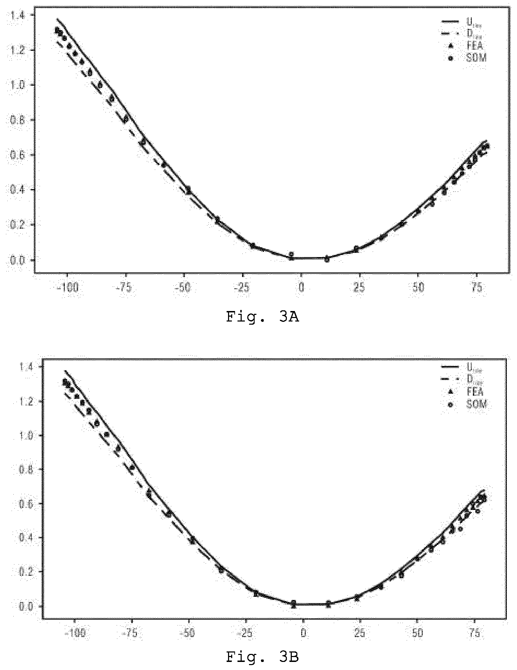

For example, Figure 3A and Figure 3B are respectively schematic diagrams of the accuracy of an optimized sensor model set at different candidate target measurement positions, taking displacement of the C-arm of an X-ray machine as the design target. The optimal position of a physical sensor on a C-arm X-ray machine with three degrees of freedom is determined by the above method in the embodiments of the present application. In each figure, the sensor model is trained by use of the output parameters of the baseline simulation model corresponding to different candidate target measurement positions in the same target sample set as auxiliary input parameters. As shown in Figure 3A and Figure 3B, the predictions from the optimized sensor model and the baseline simulation model corresponding to different target measurement positions are shown respectively in the two figures. The triangular dots at the center are the outputs of the baseline simulation model (FEA), i.e., the accuracy calibration benchmark, the two curves (Uₗᵢₙₑ and Dₗᵢₙₑ) constitute the error range of the accuracy, and the round dots are the outputs of the optimized sensor model (SOM) set. By a comparison between Figure 3A and Figure 3B, it can be found that the outputs of the optimized sensor model set in Figure 3A are almost all within the accuracy error range, while several of the outputs of the sensor model set in Figure 3B are out of the accuracy error range. Therefore, the optimized sensor model set in Figure 3A exhibits better performance in evaluating displacement distributions, which also shows that, when used in combination with the corresponding optimized sensor model, a physical sensor (if needed) placed at the candidate target measurement position corresponding to Figure 3A can be used to provide more accurate predictions.

It can be seen that the principle of the method shown in Figure 2A can be that shown in Figure 2B, wherein, based on the target sample set 310, the candidate target measurement positions 321, 322, ..., 32n are successively determined, an optimized sensor model set 331, 332, ..., 33n can be obtained based on the candidate target measurement positions 321, 322, ..., 32n determined each time, and then the optimal target measurement positions and the corresponding optimized sensor model set 340 are obtained based on comprehensive evaluation. Specifically, the candidate target measurement position determined each time may be a single target measurement position or a combination of target measurement positions.

In subsequent applications, physical sensors can be arranged at the corresponding candidate target measurement positions according to actual conditions, the optimized sensor models can be used to perform simulation measurement at other target measurement positions, and the measurement values of the physical sensors, i.e., the output parameters, can be used as auxiliary input parameters for each optimized sensor model.

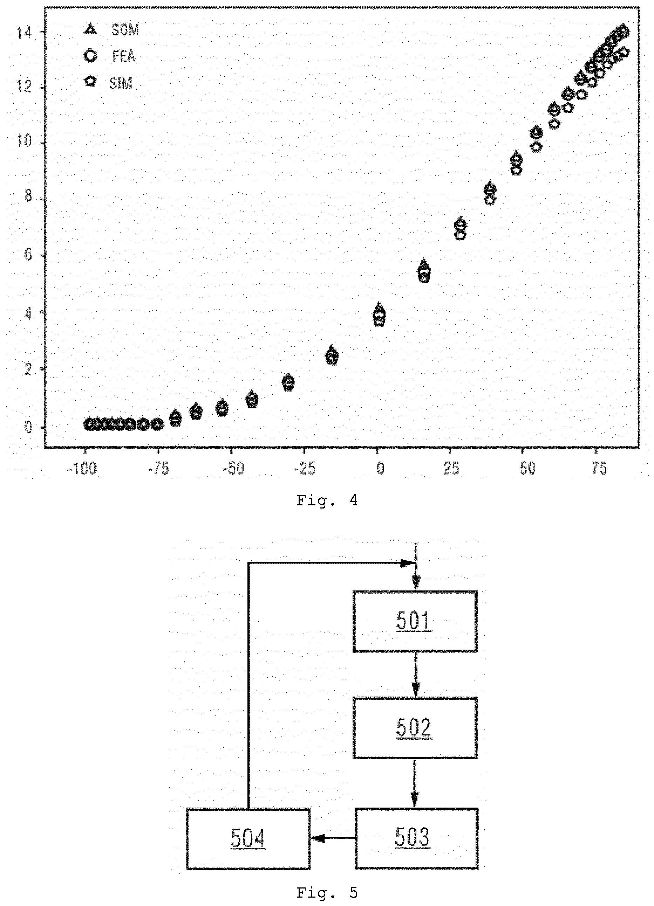

Figure 4 is a schematic diagram of a comparison of the outputs from the baseline simulation model, an initial sensor model and an optimized sensor model at different target measurement positions, wherein, the round dots are the outputs of the baseline simulation model (FEA), the pentagon dots are the outputs of the initial sensor model (SIM), and the triangle dots are the outputs of the optimized sensor model (SOM). It can be seen that the outputs of the optimized sensor model are relatively close to the outputs of the baseline simulation model from beginning to end, while the outputs of the initial sensor model gradually deviate from the outputs of the baseline simulation model from a certain section. That is, the output accuracy of the optimized sensor model based on the outputs of physical sensors as auxiliary input parameters is better than that of the initial sensor model.

Of course, in other implementations, physical sensors, optimized models and initial sensor models may also be used in combination; or only initial sensor models and physical sensors are used at the same time, but the measured values of the physical sensors are not used as auxiliary input parameters of the initial sensor models; or alternatively, only initial sensor models may be used.

For example, a sensor measurement method is also proposed in the embodiments of the present invention, which may comprise the following steps: at M1 measurement positions among M measurement positions, using N sensor models for simulated measurement; at the remaining M2 measurement positions among the M measurement positions, using M2 physical sensors for real measurement; wherein, M = M1 + M2, M1 is greater than or equal to N; and M, M1 and N are each an integer greater than or equal to 1, and M2 is an integer greater than or equal to 0; the N sensors comprise N1 initial sensor models and N2 optimized sensor models taking the output values of the M2 physical sensors as auxiliary input parameters; wherein, N = N1 + N2, N1 and N2 each are an integer greater than or equal to 0, and they are not simultaneously 0.

The sensor model generation method and the sensor measurement method in the embodiments of the present invention are described in detail above, and the sensor model generation system and the sensor measurement system in the embodiments of the present invention will be described in detail below. The sensor model generation system in the embodiments of the present invention can be used to implement the sensor model generation method in the embodiments of the present invention.

The sensor measurement system in the embodiments of the present invention can be used to implement the sensor measurement method in the embodiments of the present invention. Details not disclosed in the system embodiments of the present invention can be found in the corresponding description of the method embodiments of the present invention, and will not be detailed here.

Figure 5 is an exemplary structural diagram of a sensor model generation system in the embodiments of the present invention. As shown in Figure 5, the system may comprise: a first determining module 501, a sample obtaining module 502, a first model training module 503 and a model confirming module 504.

Among them, the first determining module 501 is used to determine at least one set of input parameter samples of a baseline simulation model.

The sample obtaining module 502 is used to, for each set of input parameter samples, input the input parameter samples into the baseline simulation model, to obtain a corresponding set of output parameters, and select the output parameters corresponding to a plurality of predetermined target measurement positions from the set of output parameters as the output parameter samples of a plurality of target sensors; and store the input parameter samples and the output parameter samples in a sample set as one set of samples.

The first model training module 503 is used to, for a single target sensor or a combination of target sensors, train a constructed neural network by use of the input parameter sample of each sample in a first number of samples in the sample set and an output parameter corresponding to the single target sensor or the combination of target sensors, to obtain a temporary sensor model corresponding to the single target sensor or the combination of target sensors; and verify output accuracy of the temporary sensor model by use of the input parameter sample of each sample in the remaining second number of samples in the sample set and an output parameter corresponding to the single target sensor or the combination of target sensors.

The model confirming module 504 is used to, for at least one temporary sensor model, when the verified accuracy meets a first set requirement, take each temporary sensor model as an initial sensor model of the corresponding single target sensor or combination of target sensors. Further, the model confirming module 504 is also used to, when the verified accuracy does not meet the first set requirement, notify the first determining module 501 to perform the operation to determine at least one set of input parameter samples of the baseline simulation model.

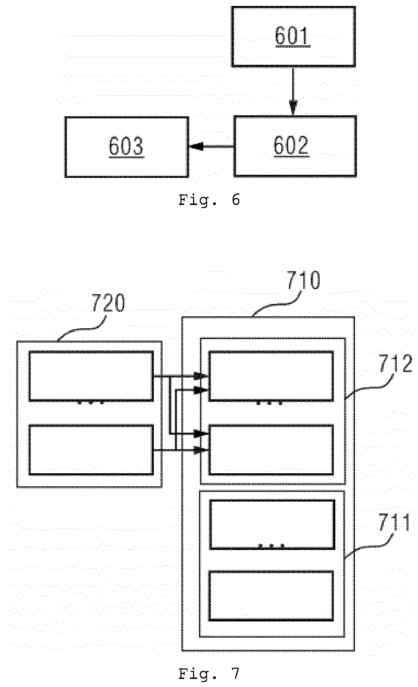

Figure 6 is an exemplary structural diagram of another sensor model generation system in the embodiments of the present invention. As shown in Figure 6, the system may comprise: a second determining module 601, a second model training module 602 and a decision making module 603.

The second determining module 601 is used to take the sample set of the initial sensor model of each single target sensor and/or combination of target sensors obtained by training in the embodiment shown in Figure 5 as a target sample set. The second model training module 602 is used to, for at least one current candidate target measurement position to be arranged for a single physical sensor or a combination of physical sensors determined in a set manner, for a single target sensor or a combination of target sensors at other target measurement positions, select at least one output parameter corresponding to the at least one current candidate target measurement position from the output parameter samples of each sample in the target sample set as a current auxiliary input parameter, add it to the input parameter samples of the sample to form current input parameter samples, and train a constructed neural network by use of the current input parameter sample of each sample in a first number of samples in the target sample set and an output parameter corresponding to the single target sensor or the combination of target sensors, to obtain an optimized sensor model corresponding to the single target sensor or the combination of target sensors; and verify output accuracy of the optimized sensor model by use of the current input parameter sample of each sample in a second number of samples in the target sample set and an output parameter corresponding to the single target sensor or the combination of target sensors; for at least one current candidate target measurement position, obtain an optimized sensor model set comprising at least one optimized sensor model of other target measurement positions.

The decision making module 603 is used to, according to each optimized sensor model set obtained at each candidate target measurement position, select at least one final candidate target measurement position and a final optimized sensor model set based on the verified accuracy of each optimized sensor model.

In specific implementation, the sensor model generation system shown in Figure 5 and Figure 6 may be implemented in different devices, or may be implemented in the same device.

Figure 7 is an exemplary structural diagram of a sensor measurement system in the embodiments of the present invention. As shown in Figure 7, the system may comprise N sensor models 710 and M2 physical sensors 720.

Among them, the N sensor models 710 are used to perform simulated measurement at M1 measurement positions among M measurement positions.

The M2 physical sensors 720 are used for real measurement at the remaining M2 measurement positions among the M measurement positions.

Specifically, M = M1 + M2, M1 is greater than or equal to N; and M, M1 and N are each an integer greater than or equal to 1, and M2 is an integer greater than or equal to 0. The N sensor models comprise N1 initial sensor models 711 and N2 optimized sensor models 712 taking the output values of the M2 physical sensors as auxiliary input parameters; wherein, N = N1 + N2, N1 and N2 each are an integer greater than or equal to 0, and they are not simultaneously 0.

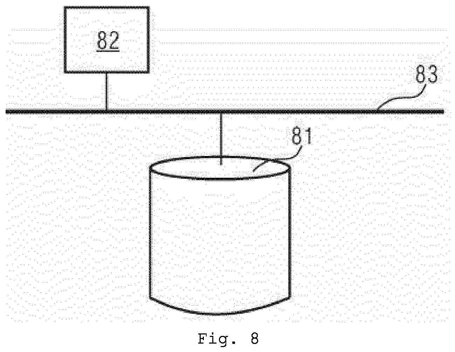

Figure 8 is a schematic structural diagram of another sensor model generation system in the embodiments of the present invention. As shown in Figure 8, the system may comprise: at least one memory 81 and at least one processor 82. In addition, some other components, for example, communication ports, etc., may also be comprised. These components communicate via a bus 83.

Specifically, the at least one memory 81 is used to store a computer program. In one implementation, the computer program may be understood as comprising each of the modules of the sensor model generation system as shown in Figure 5 and/or Figure 6. In addition, the at least one memory 81 may also store an operating system, etc. The operating system may be but is not limited to: an Android operating system, a Symbian operating system, a Windows operating system, a Linux operating system, etc.

The at least one processor 82 is used to call the computer program stored in the at least one memory 81 to execute the sensor model generation method described in the embodiments of the present invention. The processor 82 may be a CPU, a processing unit/module, an ASIC, a logic module, a programmable gate array, etc. It can receive and send data through the communication ports.

It should be noted that not all steps and modules in the above flowcharts and structural diagrams are necessary, and some steps or modules can be ignored based on actual needs. The sequence of execution of the steps is not fixed, and can be adjusted as needed. A functional division of the modules is used only to facilitate the description. In actual implementation, a module may be implemented by multiple modules, and the functions of multiple modules may be implemented by a single module. These modules may be located in a single device or in different devices.

It is understandable that the hardware modules in each embodiment above may be implemented mechanically or electronically. For example, a hardware module may comprise specially designed permanent circuits or logic devices (for example, dedicated processors, such as FPGA or ASIC) to complete specific operations. A hardware module may also comprise programmable logic devices or circuits temporarily configured by software (for example, general-purpose processors or other programmable processors) for performing specific operations. Whether to specifically use mechanical methods or dedicated permanent circuits or temporarily configured circuits (such as software configuration) to implement hardware modules may be determined according to cost and schedule considerations.

Moreover, a computer-readable storage medium is also provided in the embodiments of the present invention, which has a computer program stored thereon, which can be executed by a processor and implement the sensor model generation method described in the embodiments of the present invention. Specifically, a system or device equipped with a storage medium may be provided, and the software program code for implementing the functions of any of the above implementations is stored on the storage medium, so that a computer (or CPU or MPU) of the system or device reads and executes the program code stored in the storage medium. In addition, the operating system operating on the computer may also be used to perform part or all of the actual operations through instructions based on the program code. It is also possible to write the program code read from the storage medium to the memory provided in an expansion board inserted into the computer or to the memory provided in an expansion unit connected to the computer, and then the program code-based instructions cause the CPU, etc. mounted on the expansion board or the expansion unit to perform part and all of the actual operations, so as to implement the functions of any of the above embodiments. Implementations of the storage media used to provide the program code include floppy disks, hard disks, magneto-optical disks, optical disks (such as CD-ROM, CD-R, CD-RW, DVD-ROM, DVD-RAM, DVD-RW, DVD+RW), magnetic tapes, non-volatile memory cards and ROMs. Optionally, the program code may be downloaded from a server computer via a communication network.

It can be seen from the above solution that, in the embodiments of the present invention, the characteristic of the relatively accurate prediction value of a baseline simulation model is used to obtain a sample set comprising a large number of samples composed of input parameters and corresponding output parameters, to train a neural network model of the required physical sensors and obtain a sensor model (i.e., a virtual sensor) corresponding to the required physical sensor, and then it is possible to use the sensor model to replace individual physical sensors, to perform simulated measurement at positions of target equipment where it is not suitable to install a physical sensor; in addition, it is also possible to reduce costs by replacing some physical sensors with certain sensor models.

Moreover, sensor models at other measurement positions are trained by use of the outputs of the baseline simulation model corresponding to certain measurement positions as auxiliary input parameters, thereby further improving the output accuracy of sensor models. In this way, in practice, physical sensors may be provided at these certain measurement positions, and their outputs, i.e., measured values, may be used as auxiliary input parameters for sensor models at other measurement positions, to obtain outputs of higher accuracy from sensors at other measurement positions.

In addition, by flexible combination of physical sensors, optimized sensor models and initial sensor models, it is possible to deal with various application scenarios, thereby improving the overall measurement accuracy of target equipment.

The above are only the preferred embodiments of the present invention, and are not intended to limit the present invention. Any modification, equivalent replacement and improvement made without departing from the motivation and principle of the present invention shall be included in its scope.

## Claims

1. A sensor model generation method, **characterized in that** it comprises:
determining at least one set of input parameter samples of a baseline simulation model (S11);
for each set of input parameter samples, inputting the input parameter samples into the baseline simulation model, to obtain a corresponding set of output parameters, and selecting the output parameters corresponding to a plurality of predetermined target measurement positions from the set of output parameters as the output parameter samples of a plurality of target sensors; and storing the input parameter samples and the output parameter samples in a sample set as one set of samples (S12);
for a single target sensor or a combination of target sensors, training a constructed neural network by use of the input parameter sample of each sample in a first number of samples in the sample set and an output parameter corresponding to the single target sensor or the combination of target sensors, to obtain a temporary sensor model corresponding to the single target sensor or the combination of target sensors; and verifying output accuracy of the temporary sensor model by use of the input parameter sample of each sample in a remaining second number of samples in the sample set and an output parameter corresponding to the single target sensor or the combination of target sensors (S13);
for at least one temporary sensor model, when the verified accuracy meets a set requirement, taking each temporary sensor model as an initial sensor model of the corresponding single target sensor or combination of target sensors (S14-S15).

2. The sensor model generation method according to claim 1, **characterized in that** it further comprises: when the verified accuracy does not meet the set requirement, returning to the step of determining at least one set of input parameter samples (S15).

3. The method according to claim 1 or 2, **characterized in that** it further comprises:
taking the sample set of the initial sensor model of each single target sensor and/or combination of target sensors obtained by training as a target sample set (S21);
for at least one current candidate target measurement position to be arranged for a single physical sensor or a combination of physical sensors determined in a set manner, for a single target sensor or a combination of target sensors at other target measurement positions, selecting at least one output parameter corresponding to the at least one current candidate target measurement position from the output parameter samples of each sample in the target sample set as a current auxiliary input parameter, adding it to the input parameter samples of the sample to form current input parameter samples, and training a constructed neural network by use of the current input parameter sample of each sample in a first number of samples in the target sample set and an output parameter corresponding to the single target sensor or the combination of target sensors, to obtain an optimized sensor model corresponding to the single target sensor or the combination of target sensors; and verifying output accuracy of the optimized sensor model by use of the current input parameter sample of each sample in a second number of samples in the target sample set and an output parameter corresponding to the single target sensor or the combination of target sensors; for at least one current candidate target measurement position, obtaining an optimized sensor model set comprising at least one optimized sensor model of other target measurement positions (S22);
according to each optimized sensor model set obtained at each candidate target measurement position, selecting at least one final candidate target measurement position and a final optimized sensor model set based on the verified accuracy of each optimized sensor model (S23).

4. A sensor measurement method, **characterized in that** it comprises:
at M1 measurement positions among M measurement positions, using N sensor models for simulated measurement;
at the remaining M2 measurement positions among the M measurement positions, using M2 physical sensors for real measurement;
wherein, M = M1 + M2, M1 is greater than or equal to N; and M, M1 and N are each an integer greater than or equal to 1, and M2 is an integer greater than or equal to 0;
the N sensors comprise N1 initial sensor models and N2 optimized sensor models taking the output values of the M2 physical sensors as auxiliary input parameters; wherein, N = N1 + N2, N1 and N2 each are an integer greater than or equal to 0, and they are not simultaneously 0;
the initial sensor model is obtained by the sensor model generation method claimed in claim 1 or 2;
the optimized sensor model and the measurement positions of the M2 physical sensors are obtained by the sensor model generation method claimed in claim 3.

5. A sensor model generation system, **characterized in that** it comprises:
a first determining module (501), used to determine at least one set of input parameter samples of a baseline simulation model;
a sample obtaining module (502), used to, for each set of input parameter samples, input the input parameter samples into the baseline simulation model, to obtain a corresponding set of output parameters, and select the output parameters corresponding to a plurality of predetermined target measurement positions from the set of output parameters as the output parameter samples of a plurality of target sensors; and store the input parameter samples and the output parameter samples in a sample set as one set of samples;
a first model training module (503), used to, for a single target sensor or a combination of target sensors, train a constructed neural network by use of the input parameter sample of each sample in a first number of samples in the sample set and an output parameter corresponding to the single target sensor or the combination of target sensors, to obtain a temporary sensor model corresponding to the single target sensor or the combination of target sensors; and verify output accuracy of the temporary sensor model by use of the input parameter sample of each sample in a remaining second number of samples in the sample set and an output parameter corresponding to the single target sensor or the combination of target sensors; and
a model confirming module (504), used to, for at least one temporary sensor model, when the verified accuracy meets a first set requirement, take each temporary sensor model as an initial sensor model of the corresponding single target sensor or combination of target sensors.

6. The sensor model generation system according to claim 5, **characterized in that** the model confirming module (504) is further used to, when the verified accuracy does not meet the first set requirement, notify the first determining module (501) to perform the operation to determine at least one set of input parameter samples of the baseline simulation model.

7. The sensor model generation system according to claim 5 or 6, **characterized in that** it further comprises:
a second determining module (601), used to take the sample set of the initial sensor model of each single target sensor and/or combination of target sensors obtained by training as a target sample set;
a second model training module (602), used to, for at least one current candidate target measurement position to be arranged for a single physical sensor or a combination of physical sensors determined in a set manner, for a single target sensor or a combination of target sensors at other target measurement positions, select at least one output parameter corresponding to the at least one current candidate target measurement position from the output parameter samples of each sample in the target sample set as a current auxiliary input parameter, add it to the input parameter samples of the sample to form current input parameter samples, and train a constructed neural network by use of the current input parameter sample of each sample in a first number of samples in the target sample set and an output parameter corresponding to the single target sensor or the combination of target sensors, to obtain an optimized sensor model corresponding to the single target sensor or the combination of target sensors; and verify output accuracy of the optimized sensor model by use of the current input parameter sample of each sample in a second number of samples in the target sample set and an output parameter corresponding to the single target sensor or the combination of target sensors; for at least one current candidate target measurement position, obtain an optimized sensor model set comprising at least one optimized sensor model of other target measurement; and
a decision making module (603), used to, according to each optimized sensor model set obtained at each candidate target measurement position, select at least one final candidate target measurement position and a final optimized sensor model set based on the verified accuracy of each optimized sensor model.

8. A sensor measurement system, **characterized in that** it comprises:
N sensor models (710), used to perform simulated measurement at M1 measurement positions among M measurement positions; and
M2 physical sensors (720), used for real measurement at the remaining M2 measurement positions among the M measurement positions;
wherein, M = M1 + M2, M1 is greater than or equal to N; and M, M1 and N are each an integer greater than or equal to 1, and M2 is an integer greater than or equal to 0;
the N sensor models comprise N1 initial sensor models (711) and N2 optimized sensor models (712) taking the output values of the M2 physical sensors as auxiliary input parameters; wherein, N = N1 + N2, N1 and N2 each are an integer greater than or equal to 0, and they are not simultaneously 0;
the initial sensor model (711) is obtained by the sensor model generation method claimed in claim 5 or 6;
the optimized sensor model (712) and the measurement positions of the M2 physical sensors are obtained by the sensor model generation method claimed in claim 7.

9. A sensor model generation system, **characterized in that** it comprises: at least one memory (81) and at least one processor (82), wherein:
the at least one memory (81) is used to store a computer program; and
the at least one processor (82) is used to call the computer program stored in the at least one memory (81) to execute the sensor model generation method claimed in any of claims 1 to 3.

10. A computer-readable storage medium, which has a computer program stored thereon; and is **characterized in that** the computer program can be executed by a processor and implement the sensor model generation method claimed in any of claims 1 to 3.
